# EUROPEAN PATENT APPLICATION

(11) **EP 4 538 626 A1**
(43) Date of publication of application: **16.04.2025**
(21) Application number: 23203493.4
(22) Date of filing: 13.10.2023
(51) Int. Cl.: F28D 15/04

(54) **A TWO-SIDE FLAT EVAPORATOR**

(71) Applicant: Allatherm SIA, 2015 Jurmala (LV)
(72) Inventor: MISHKINIS, Donatas, LV-2015 Jurmala (LV)
(74) Representative: Vitina, Maruta

(57) **Abstract**

The invention relates to a flat loop heat pipe evaporator, which may be used for aerospace or terrestrial electronic equipment cooling and thermal management. A two-side flat evaporator comprises a casing comprising two high thermal conductivity interface plates (101, 102), and a surrounding low thermal conductivity envelope (103); wherein the low thermal conductivity envelope (103) has an upper part (119) and a lower part (120) and an evaporator's side wall (115); a wick (111), placed in the space between the interface plates (101, 102) and partially inside the low thermal conductivity envelope (103); a liquid line port (118) crossing the wrap-around vapor collecting gap (108); a compensation chamber designed in the form of an wrap-around compensation chamber (112) surrounding the wick (111) and placed inside the low thermal conductivity envelope (103).

## Description

### TECHNICAL FIELD

The invention relates to the technical field of heat dissipation, in particular to an efficient heat transfer, namely, to a flat loop heat pipe evaporator, which may be used for aerospace or terrestrial electronic equipment cooling or thermal management.

### BACKGROUND

A heat loops (HL) also known as loop heat pipes, capillary pumped loops, capillary driven loops, etc. are used as thermal management systems (cooling & temperature control) for a wide range of applications in the energy, scientific, medical equipment, telecommunication, automotive, aerospace, and defense industries. HL is an efficient two-phase heat transfer device, which has high heat transfer performance, long-distance heat transfer capacity, excellent temperature control property, and high pipe bending flexibility, and is convenient to install. Thermal management of various objects can be provided with help of HLs, for example such as: microelectronics, mobile devices, laptops, tablets, notebooks, computers, servers, power electronics, batteries, lasers, data centers, alternative energy sources, LEDs, fuel cells, unmanned aircraft and vehicles, high-altitude balloons, material processing, energy recovery equipment, etc.

HL is a passive heat transfer device which generally consist of an evaporator, vapor and liquid transport lines (usually small diameter tubing) and a condenser. Heat transfer in a HL is provided by evaporation-condensation cycle. A capillary pump (wick) in the evaporator provides liquid return from a condenser.

The evaporator is a principal part of a HL.

The closest known device [CN105371676A] is flat two-side evaporator, comprising a casing, consisting of an upper cover and a lower cover, an upper wick and a lower wick, placed within the casing, two compensation chambers, a plurality of vapor grooves placed between the wicks and the casing, a wrap-around vapor collecting gap, formed by an evaporator's side wall, a liquid line port crossing the wrap-around vapor collecting gap, the liquid line port is hydraulically connected to a vapor line port through the compensation chamber and the wick with at least one peripheral vapor channel

However, this device has several drawbacks. It is impossible to use this design so that one of interface plates can serve as a heat sink. The compensation chamber is inside the wick which increases the overall thickness of the evaporator and has a negative impact on the compactness of the device. Also, location of the compensation chamber inside of the evaporator increases parasitic conductive heat leak through the wick and reduces the effective thermal conductance of the evaporator and the heat loop in comparison with a evaporator design wherein the compensation chamber is located on the sides of the evaporator.

### BRIEF DISCLOSURE OF THE INVENTION

The technical problem to be solved by the present invention is to improve compactness, to reduce parasitic heat leak and to increase the efficient thermal conductance of the evaporator and the heat loop.

In a two-side flat evaporator comprising: a casing, a wick, placed within the casing, a plurality of vapor grooves placed between the wick and casing, a wrap-around vapor collecting gap, surrounded by an evaporator's side wall, a liquid line port crossing the wrap-around vapor collecting gap, wherein the liquid line port is hydraulically connected to a vapor line port through a compensation chamber and the wick with at least one peripheral vapor channel, according to the present invention, the casing comprises two high thermal conductivity interface plates - an upper interface plate and an lower interface plate, and a surrounding low thermal conductivity envelope, wherein the low thermal conductivity envelope has an upper part and a lower part and an evaporator's side wall, the wick is placed in the space between the upper interface plate and the lower interface plate and partially inside the low thermal conductivity envelope, the vapor grooves are placed between the high thermal conductivity interface plates and the wick, the compensation chamber is designed in the form of an wrap-around compensation chamber surrounding the wick, said wrap-around compensation chamber is placed inside the low thermal conductivity envelope, the wrap-around vapor collecting gap is placed between a thermal insulation barrier of the wrap-around compensation chamber and the evaporator's side wall, a wick sealing is placed on a peripheral part of the wick inside the low thermal conductivity envelope.

The low thermal conductivity envelope, located aside of heat source, decreases parasitic heat leaks to the evaporator liquid part (the wrap-around compensation chamber and the liquid line port) since these heat leaks can cause intensive boiling of the liquid, which will lead to fluid circulation stoppage and cause the loop operation failure due to the dry out of the wick.

The compensation chamber is designed in the form of a wrap-around compensation chamber surrounding the wick thus providing an efficient liquid supply arrangement to the wick and a possibility to design the evaporator in any shape.

The undesirable heat exchange between the cold liquid in the wrap-around compensation chamber and the hot vapor in the wrap-around vapor collecting gap is avoided by the thermal insulation barrier on the compensation chamber wall.

The wick sealing may be designed as plastic O-rings, knife-type assembly, or be brazed, or be welded.

The vapor grooves may be designed as a plurality of vapor removing grooves fabricated on the high thermal conductivity interface plates and/or directly on the wick.

On the high thermal conductivity interface plates and/or directly on the wick may be additionally placed a plurality direct vapor collecting grooves, and surrounding vapor collecting grooves.

The thermal insulation barrier may be attached to a wrap-around compensation chamber wall.

The thermal insulation barrier may be a polymer (for instance, Teflon) or resin layer or a vacuum gap.

The evaporator may comprise multiple peripheral vapor channels.

The wick may be designed with a plurality of internal liquid supply channels directed from the wrap-around compensation chamber to the central part of the wick.

The liquid line port and the vapor line port may be located independently at any position on the evaporator's side wall.

The high thermal conductivity interface plates may be designed to correspond to a shape and a size of an object to be cooled (i.e., heat source). The high thermal conductivity interface plates may have the same shape and size as the object to be cooled or may be larger.

The surrounding low thermal conductivity envelope may be designed in the shape corresponding to a volume available in the device containing an object to be cooled. The wrap-around compensation chamber which is placed inside the surrounding low thermal conductivity envelope should have a specified volume calculated according to the heat loop design rules, said volume depends on the volume of the HL, the transport lines and the condenser. The proposed design provides a possibility to adjust the shape of the compensation chamber and the surrounding low thermal conductivity envelope in compliance with an available volume for the evaporator.

The upper and lower parts of the surrounding low thermal conductivity envelope may have the same shape as the high thermal conductivity interface plates. Such design has advantages for production.

The surrounding low thermal conductivity envelope and the high thermal conductivity interface plates may have different shapes if available volume for evaporator installation is limited. The surrounding low thermal conductivity envelope may be designed for a specific equipment to be cooled and corresponds to the available volume within it.

### BRIEF DESCRIPTION OF DRAWINGS

The present invention is explained by drawings, wherein is shown:
Fig. 1. - isometric drawing of an embodiment of the proposed evaporator with partial sectional view;
Fig. 2 - schematic sectional view of the embodiment of the evaporator shown in Fig. 1;
Fig. 3 - schematic sectional view of a heat loop with the proposed evaporator;
Fig. 4 - isometric drawing of another embodiment of the proposed evaporator with partial sectional view;
Fig. 5 - embodiments of the proposed evaporator with different locations of the liquid line port and the vapor line port;
Fig. 6 - an embodiment of the proposed evaporator wherein the surrounding low thermal conductivity envelope has the same shape as the high thermal conductivity interface plates;
Fig. 7 - embodiments of the proposed evaporator wherein the high thermal conductivity interface plates and the surrounding low thermal conductivity envelope have different shapes.

### DETAILED DISCLOSURE OF THE INVENTION

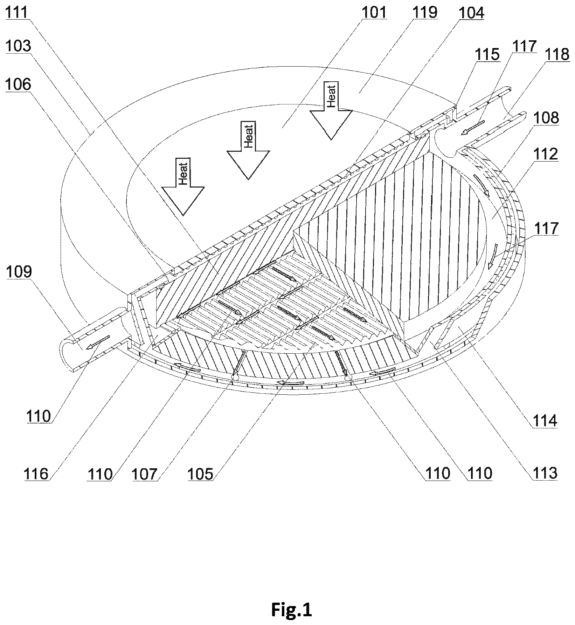

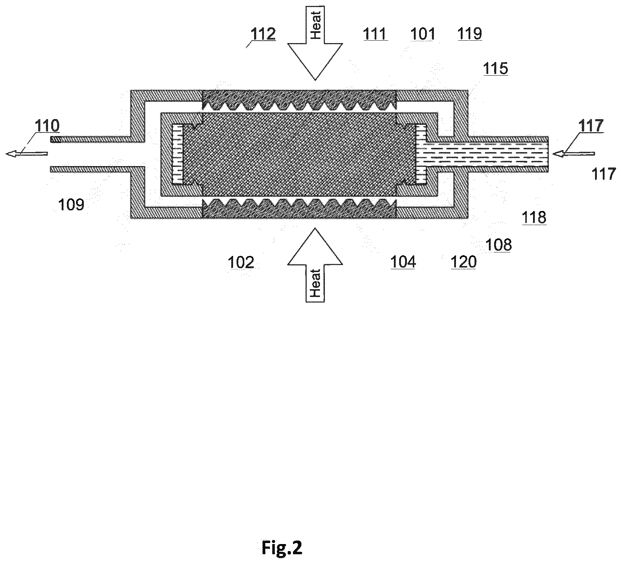

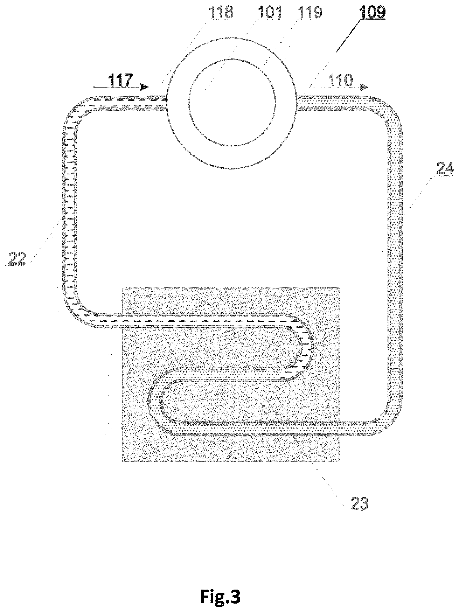

The two-side flat evaporator (shown in Fig. 1 and more schematic in Fig. 2) includes two high thermal conductivity interface plates - an upper interface plate 101 and a lower interface plate 102 (for instance, made of copper) and a surrounding low thermal conductivity envelope 103 (for instance, made of stainless steel). The low thermal conductivity envelope 103 has an upper part 119 and a lower part 120 and a side wall which is also an evaporator's side wall 115. A wick 111 is placed in the space between the upper interface plate 101 and the lower interface plate 102, and partially inside the low thermal conductivity envelope 103. The compensation chamber is designed in the form of a wrap-around compensation chamber 112 and is surrounding the wick 111; said wrap-around compensation chamber 112 is placed inside the low thermal conductivity envelope 103. The compensation chamber 112 is connected with a liquid line port 118 for supply of liquid from a liquid transport line 22 (in Fig. 3 is shown a schematic sectional view of a heat loop with the proposed evaporator wherein the evaporator is shown as not sectioned). A plurality of vapor removing grooves 104 and direct vapor collecting grooves 105 and surrounding vapor collecting grooves 106 can be made on the interface plates 101, 102 (as it is shown in Figs. 1 and 2) or/and directly on the wick 111 (not shown). A wrap-around vapor collecting gap 108 is placed between the thermal insulation barrier 114 of the compensation chamber 112 and the evaporator side wall 115, wherein a liquid line port 118 crosses the vapor collecting wrap-around gap 108. The vapor collecting wrap-around gap 108 is hydraulically connected with multiple peripheral vapor channels 107 and a vapor line port 109. To provide efficient hydraulic separation between a high-pressure vapor part (vapor flow direction 110) and a low-pressure liquid part (liquid flow direction 117) of the evaporator, the wick sealing 116 is used. The wick sealing 116 can be designed as plastic O-rings (as it is shown in the Figs. 1 and 2), or as knife-type assembly, can be brazed, welded, or made by other methods (not shown).

To minimize undesirable heat exchange between the cold liquid in said wrap-around compensation chamber 112 and the hot vapor in wrap-around vapor collecting gap 108, the thermal insulation barrier 114 (for instance, polymer or resin layer or a vacuum gap) is attached to the wrap-around compensation chamber wall 113.

The evaporator is operating in a following manner. Liquid (ammonia, butane, propylene or other refrigerant; its flow direction is illustrated by arrows 117) from a condenser 23 (shown in Fig. 3) through the liquid transport line 22 is arriving at the liquid line port 118 and filling the wrap-around compensation chamber 112 which is surrounding the wick 111. It is important that the liquid line port 118 is crossing the wrap-around vapor collecting gap 108. Then, by capillary forces, the liquid is moving through the wick 111 to the high thermal conductivity interface plates 101, 102 (there are two plates: the upper plate and the lower plate; terms "upper" and "lower" are relative because the evaporator is two sided and may be used also in opposite way). Evaporation takes place on the wick 111 surfaces in the front of the interface plates 101, 102 since the heat (shown by arrows) is applied to the upper interface plate 101 and the lower interface plate 102 (the upper interface plate 101 and the lower interface plate 102 are in contact with a heat generating object or objects). Thus, applied heat is converted into a latent heat of working liquid as a result of phase transition. Generated vapor (its flow direction is illustrated by arrows 110) is flowing in the multiple vapor removing grooves 104 towards the direct vapor collecting grooves 105 and the surrounding vapor collecting groove 106. Then the vapor is moving to the wrap-around vapor collecting gap 108 through the multiple peripheral vapor channels 107. Finally, the vapor is arriving to the vapor line port 109 and moves to the heat loop condenser 23 through a vapor transport line 24 (shown in Fig.3) where vapor condensation take place (heat is released). The formed liquid is moving back to the liquid line port 118 through the liquid transport line 22. The undesirable heat exchange between the cold liquid in the wrap-around compensation chamber 112 and the hot vapor in the wrap-around vapor collecting gap 108 is avoided by the thermal insulation barrier 114 on the compensation chamber wall 113. The low thermal conductivity envelope 103 decreases parasitic heat leaks to the evaporator liquid part (the wrap-around compensation chamber 112 and the liquid line port 118) since these heat leaks can cause intensive boiling of the liquid, which will lead to fluid circulation stoppage and cause the loop operation failure due to the dry out of the wick 111.

If the heat is applied only to one of the interface plates (to the upper interface plate 101 or to the lower interface plate 102) the opposite interface plate may be used as a heat sink. In this case the total input heat flow is divided in the two flows: one goes to the condenser 23 and the other - to the opposite interface plate operating as the heat sink.

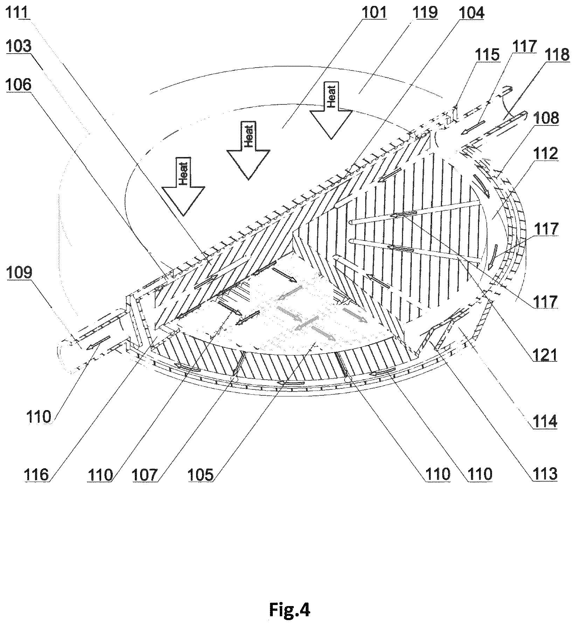

Another embodiment of the two-side flat evaporator (shown in Fig. 4) is designed similarly as described in Example 1. The wick 111 is designed with plurality of internal liquid supply channels 121 directed from the wrap-around compensation chamber 112 to the central part of the wick 111. The internal liquid supply channels 121 provide more effective supply of the liquid to the whole volume of the wick 111.

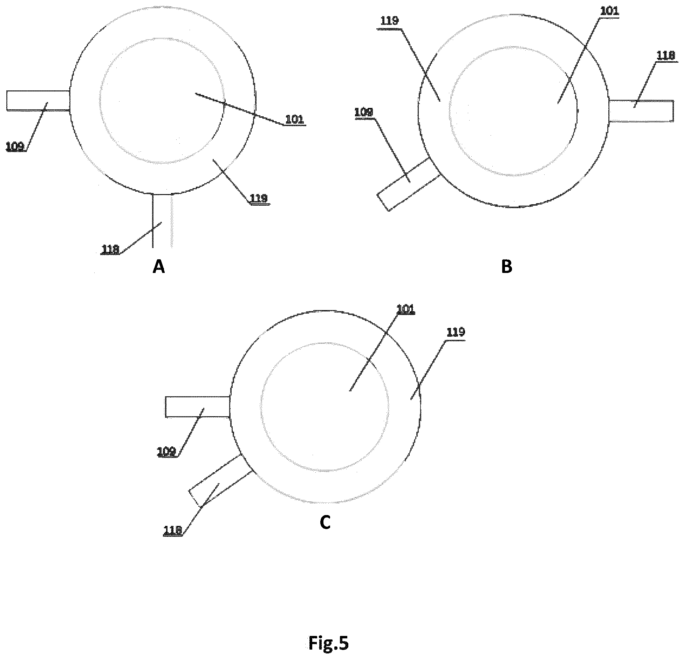

In Fig. 5 are shown another embodiments of the proposed evaporator wherein the surrounding low thermal conductivity envelope 103 and its upper part 119 and lower part 120 and the high thermal conductivity interface plates 101 and 102 have the shape of a circle, but the liquid line port 118 and the vapor line port 109 are positioned at different locations:
A - the liquid line port 118 and the vapor line port 109 are located with an angle 90 ° between them;
B - the liquid line port 118 and the vapor line port 109 are located with an angle 120 ° between them;
C - the liquid line port 118 and the vapor line port 109 are located close each to other

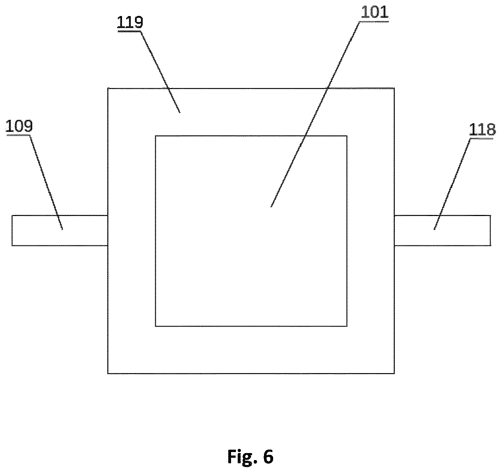

In Fig. 6 is shown an embodiment of the proposed evaporator wherein the surrounding low thermal conductivity envelope 103 and its upper part 119 and lower part 120 and the high thermal conductivity interface plates 101 and 102 have the shape of the square.

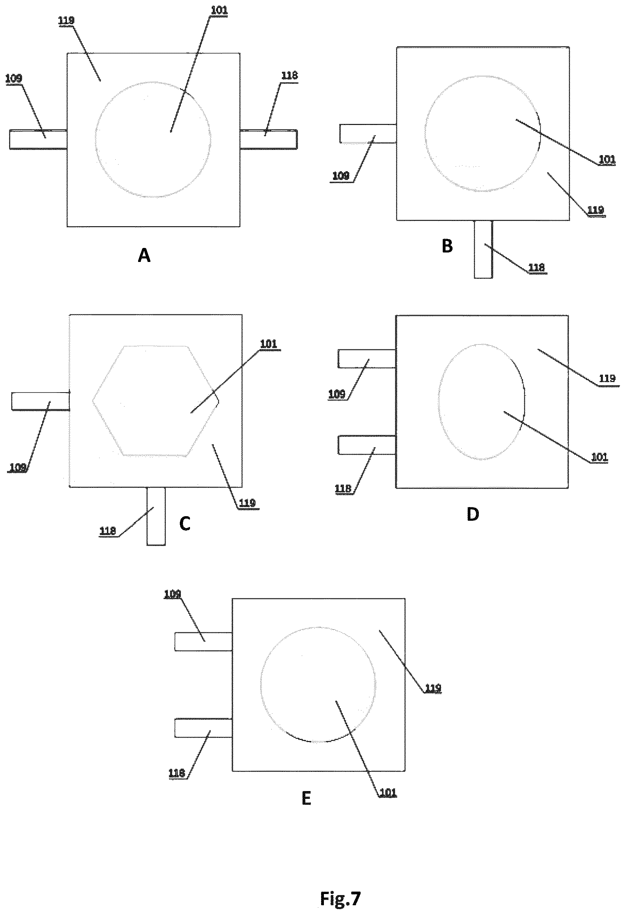

In Fig. 7 are shown embodiments of the proposed evaporator wherein the high thermal conductivity interface plates 101 and 102 and the surrounding low thermal conductivity envelope 103 and its upper part 119 and lower part 120 have different shapes:
A - the high thermal conductivity interface plates 101 and 102 have the shape of a circle and
the surrounding low thermal conductivity envelope 103 and its upper part 119 and lower part 120 have the shape of a square;
B - the high thermal conductivity interface plates 101 and 102 have the shape of a circle and
the surrounding low thermal conductivity envelope 103 and its upper part 119 and lower part 120 have the shape of a square, and the liquid line port 118 and the vapor line port 109 are located with an angle 90 ° between them;
C - the high thermal conductivity interface plates 101 and 102 have the shape of a hexagon and the surrounding low thermal conductivity envelope 103 and its upper part 119 and lower part 120 have the shape of a square, and the liquid line port 118 and the vapor line port 109 are located with an angle 90 ° between them;
D- the high thermal conductivity interface plates 101 and 102 have the shape of an oval and the surrounding low thermal conductivity envelope 103 and its upper part 119 and lower part 120 have the shape of a square, and the liquid line port 118 and the vapor line port 109 are located close each to other;
E - the high thermal conductivity interface plates 101 and 102 have the shape of a circle and the surrounding low thermal conductivity envelope 103 and its upper part 119 and lower part 120 have the shape of a square, and and the liquid line port 118 and the vapor line port 109 are located close each to other.

## Claims

1. A two-side flat evaporator comprising:
a casing,
a wick (111), placed within the casing,
a plurality of vapor removing grooves (104) placed between the wick (111) and casing,
a wrap-around vapor collecting gap (108), surrounded by an evaporator's side wall (115),
a liquid line port (118) crossing the wrap-around vapor collecting gap (108),
wherein the liquid line port (118) is hydraulically connected to a vapor line port (109) through a compensation chamber (112) and the wick (111) with at least one peripheral vapor channel (107),
**characterized in that** the casing comprises two high thermal conductivity interface plates (101, 102) - an upper interface plate (101) and an lower interface plate (102), and a surrounding low thermal conductivity envelope (103), wherein the low thermal conductivity envelope (103) has an upper part (119) and a lower part (120) and an evaporator's side wall (115),
the wick (111) is placed in the space between the upper interface plate (101) and the lower interface plate (102) and partially inside the low thermal conductivity envelope (103),
the vapor grooves are placed between the high thermal conductivity interface plates (101, 102) and the wick (111),
the compensation chamber is designed in the form of an wrap-around compensation chamber (112) surrounding the wick (111), said wrap-around compensation chamber (112) is placed inside the low thermal conductivity envelope (103),
the wrap-around vapor collecting gap (108) is placed between a thermal insulation barrier (114) of the wrap-around compensation chamber (112) and the evaporator's side wall (115),
a wick sealing (116) is placed on a peripheral part of the wick (111) inside the low thermal conductivity envelope (103).

2. The evaporator according to claim 1, wherein the wick sealing (116) is designed as plastic O-rings, knife-type assembly, or is brazed, or is welded.

3. The evaporator according to claim 1, wherein the plurality of vapor removing grooves (104) placed between the wick (111) and casing are fabricated on the high thermal conductivity interface plates (101, 102) and/or directly on the wick (111).

4. The evaporator according to claim 3, wherein on the high thermal conductivity interface plates (101, 102) and/or directly on the wick (111) is additionally placed a plurality of direct vapor collecting grooves (105) and surrounding vapor collecting grooves (106).

5. The evaporator according to claim 1, wherein the thermal insulation barrier (114) is attached to a wrap-around compensation chamber wall (113).

6. The evaporator according to claim 5, wherein the thermal insulation barrier (114) is a Teflon layer or a vacuum gap.

7. The evaporator according to claim 1, wherein the evaporator comprises multiple peripheral vapor channels (107).

8. The evaporator according to claim 1, wherein the wick (111) is designed with a plurality of internal liquid supply channels (121) directed from the wrap-around compensation chamber (112) to the central part of the wick (111).

9. The evaporator according to claim 1, wherein the liquid line port (118) and the vapor line port (109) are located independently at any position on the evaporator's side wall (115).

10. The evaporator according to claim 1, wherein the high thermal conductivity interface plates (101, 102) are designed to correspond to a shape and a size of an object to be cooled.

11. The evaporator according to claim 1, wherein the surrounding low thermal conductivity envelope (103) is designed in the shape corresponding to a volume available in the device containing an object to be cooled.

12. The evaporator according to claim 1, wherein the upper and lower parts (119, 120) of the surrounding low thermal conductivity envelope (103) have the same shape as the high thermal conductivity interface plates (101, 102).

13. The evaporator according to claim 1, wherein upper and lower parts (119, 120) of the surrounding low thermal conductivity envelope (103) and the high thermal conductivity interface plates (101, 102) have different shapes.
